(19) Europäisches Patentamt / European Patent Office / Office européen des brevets

(11) **EP 3 351 959 B1**

(12) **EUROPEAN PATENT SPECIFICATION**

(45) Date of publication and mention
of the grant of the patent:
**10.03.2021 Bulletin 2021/10**

(51) Int Cl.:
***G01S 13/72*** *(2006.01)*

(21) Application number: **18151519.8**

(22) Date of filing: **12.01.2018**

(54) **APPARATUS AND METHOD FOR PERFORMING A CONSISTENCY TESTING USING NON-LINEAR FILTERS THAT PROVIDE PREDICTIVE PROBABILITY DENSITY FUNCTIONS**

VORRICHTUNG UND VERFAHREN ZUR DURCHFÜHRUNG EINER KONSISTENZPRÜFUNG MIT NICHTLINEAREN FILTERN FÜR PROGNOSTISCHE WAHRSCHEINLICHKEITSDICHTEFUNKTIONEN

APPAREIL ET PROCÉDÉ POUR EFFECTUER UN TEST DE COHÉRENCE AU MOYEN DE FILTRES NON LINÉAIRES ASSURANT DES FONCTIONS DE DENSITÉ DE PROBABILITÉ PRÉDICTIVE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.01.2017 US 201715408534**

(43) Date of publication of application:
**25.07.2018 Bulletin 2018/30**

(73) Proprietor: **Honeywell International Inc.**
**Morris Plains, NJ 07950 (US)**

(72) Inventors:
• **VESELY, Milos**
**Morris Plains, NJ New Jersey 07950 (US)**
• **SOTAK, Milos**
**Morris Plains, NJ New Jersey 07950 (US)**
• **DUNIK, Jindrich**
**Morris Plains, NJ New Jersey 07950 (US)**

(74) Representative: **Houghton, Mark Phillip**
**Patent Outsourcing Limited**
**1 King Street**
**Bakewell, Derbyshire DE45 1DZ (GB)**

(56) References cited:
**WO-A1-2014/092995        US-A1- 2014 324 339**

• **ONDREJ STRAKA ET AL: "Performance diagnosis of local filters in state estimation of nonlinear systems", JOURNAL OF PHYSICS: CONFERENCE SERIES, INSTITUTE OF PHYSICS PUBLISHING, BRISTOL, GB, vol. 570, no. 1, 16 December 2014 (2014-12-16), page 12004, XP020275768, ISSN: 1742-6596, DOI: 10.1088/1742-6596/570/1/012004 [retrieved on 2014-12-16]**

**Description**

BACKGROUND

Extended Kalman filters are used to perform state estimation of non-linear systems. Most extended Kalman filters comprise a measurement model and a model of the non-linear system, of which states are estimated. The filters cyclically perform two steps: the prediction step and the filtering step.

In the prediction step, the model of the non-linear system is used to predict a future value of one or more states, or a predictive estimate of the states. In the filtering step, measurement data is used to correct the predictive estimate, and generates a filtered estimate of the states. The filtered estimate of the states is in the form of the first two moments of the state estimate.

The filtered estimate of the states is typically more accurate than the predictive estimate of the states because of the use of the measurement data. However, the measurement data can be inconsistent with the measurement model. For example, the measurement data may be erroneous due to noise or sensor degradation. Such inconsistent measurement data should not be used because it would corrupt the predictive estimate of the states.

Predicted measurement data can be generated with the extended Kalman filter. The measurement data can be compared to the predicted measurement data to determine if the measurement data is within an expected range of the predicted measurement data. If the measurement data is within the expected range of the predicted measurement data, the measurement data is deemed consistent, and then is used in the filtering step to compute the filtered estimate of the states. The use of only consistent measurement data ensures accurate and reliable state estimates and prevents filter divergence due to false measurements.

However, use of extended Kalman filters is not always preferable.

SUMMARY

A system and corresponding method is provided as claimed in the accompanying claims.

DRAWINGS

Understanding that the drawings depict only exemplary embodiments and are not therefore to be considered limiting in scope, the exemplary embodiments will be described with additional specificity and detail through the use of the accompanying drawings, in which:

Figure 1 illustrates an exemplary block diagram of a system including at least one non-linear filter that provides predictive measurement probability density functions;
Figure 2 illustrates an exemplary method of operation of a non-linear estimator that provides predictive measurement probability density function estimates;
Figure 3 illustrates one embodiment of a method of determining if the measurement data is consistent;
Figure 4 illustrates one embodiment of a scalar unimodal probability density function (PDF) having an allowed area and two forbidden areas;
Figure 5 illustrates one embodiment of a scalar multi-modal PDF having two allowed areas and three forbidden areas.

In accordance with common practice, the various described features are not drawn to scale but are drawn to emphasize specific features relevant to the exemplary embodiments. Reference characters denote like elements throughout figures and text.

DETAILED DESCRIPTION

In the following detailed description, reference is made to the accompanying drawings that form a part hereof, and in which is shown by way of illustration specific illustrative embodiments. However, it is to be understood that other embodiments may be utilized and that structural, mechanical, and electrical changes may be made. Furthermore, the method presented in the drawing figures and the specification is not to be construed as limiting the order in which the individual steps may be performed. The following detailed description is, therefore, not to be taken in a limiting sense.

Non-linear filters other than extended Kalman filters may be utilized to perform state estimation of non-linear systems. Some such non-linear filters provide a state estimate in the form of a probability density function (PDF) rather than in the form of the first two moments of the state estimate. Such non-linear filters include particle filters, Gaussian sum filters, point mass filters. Particle filters include Rao-Blackwellized particle filters. Point mass filters include Rao-Blackwellized point mass filters. These non-linear filters may be configured to provide both state estimates and predictive measurement probability density functions (PDFs). Techniques for performing consistency testing using non-linear filters configured to provide predictive measurement PDFs are subsequently described.

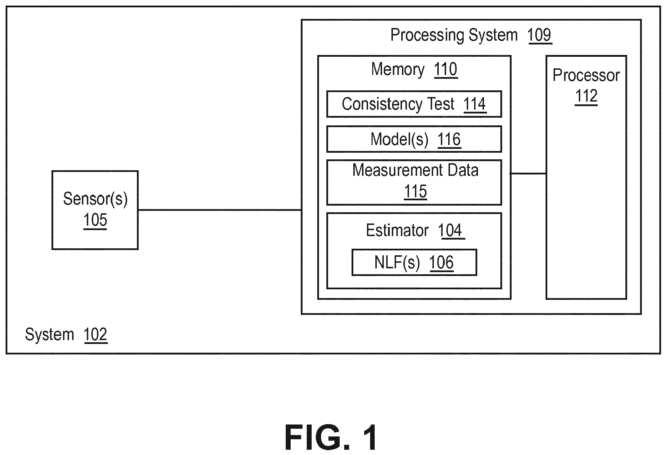

Figure 1 illustrates an exemplary block diagram of a system including at least one non-linear filter configured to provide predictive measurement PDFs (System) 102. The system including at least one non-linear filter that provides predictive measurement PDFs 102 may also be referred to herein as a system including at least one non-linear filter 102.

In one embodiment, the system 102 comprises a processing system 109 coupled to an at least one sensor 105. The at least one sensor 105 measures data. In one example, the at least one sensor 105 may measure a quantity associated with a horizontal position on a known surface. In this embodiment, the one or more sensor 105 may include one or more of altimeters (*e.g.* barometric and/or radar), pressure sensors, accelerometers (*e.g.* measuring gravity), magnetometers, gravity gradiometers, gravimeters, water depth sensors, a bathymetric echo-sounder, a camera-type sensor, star trackers, and/or inertial measurement units including accelerometer(s) and/or gyroscope(s).

In one embodiment, the processing system 109 comprises a memory 110 coupled to a processor 112. In another embodiment, an estimator 104, a consistency test 114, measurement data 115, and at least one model 116 are stored in the memory 110. In a further embodiment, other data is stored in the memory 110. The measurement data 115 is data measured by the at least one sensor 105. The consistency test 114 and the at least one model 116 will be subsequently described. In one embodiment, the consistency test 114, the at least one model 116 and the estimator 104 may be stored in the form of executable software. In another embodiment, the processing system 109 may be a state machine. In a further embodiment, the processing system 109 may be a field programmable gate array.

The estimator 104 includes the at least one non-linear filter configured to provide at least one measurement predictive PDF (NLF(s)) 106. Non-linear filters configured to provide at least one measurement predictive PDF 106 can include one or more of particle filters, Gaussian sum filters, and point mass filters. Point mass filters include Rao-Blackwellized point mass filters. Particle filters include Rao-Blackwellized particle filters. The estimator 104 is also used to estimate state parameters of the at least one model 116, *i.e.* state-space models for a non-linear system. In one embodiment, the state parameters include the horizontal position on the surface, and which is estimated based upon the at least one model 116, the measurement data 115, and the estimator 104.

In one embodiment, the at least one model 116 include without limitation a state space model for direct and/or indirect estimation of the state parameter. The state space model describes time-evolution of state parameters, *e.g.*, of the horizontal position of an object, and/or of the error (e.g. bias, noise, or correlated noise) of the at least one sensor 105. In another embodiment, the state space model comprises a state equation that is linear and a measurement equation that is non-linear. In a further embodiment, the at least one model 116 are a state space model comprising a state equation and a measurement equation. The measurement equation relates directly unmeasurable state parameters with available measurements of the at least one sensor 105. Definition of the state variables, selection of the sensor measurements, and design of the state-space model is specified by a filter designer.

The following is an exemplary state-space model describing a non-linear system. The state-space model is in a form of a state equation (for $\mathbf{x}_{k+1}$) and a measurement equation (for $\mathbf{z}_k$):

$$\mathbf{x}_{k+1} = \mathbf{f}(\mathbf{x}_k, \mathbf{u}_k, \mathbf{w}_k)$$
$$\mathbf{z}_k = \mathbf{h}(\mathbf{x}_k) + \mathbf{v}_k$$
(Equation 1)

where $\mathbf{x}_k \in R^{n_x}$ is an unknown state, which is not directly measurable, at time instant $k$, $\mathbf{u}_k \in R^{n_u}$ is a known input, $\mathbf{z}_k \in R^{n_z}$ is a measurement parameter, $\mathbf{w}_k \in R^{n_w}$ is a state noise with a known probability density function $p_w(\mathbf{w}_k)$, $v_k \in R^{n_v}$ is a measurement noise with a known probability density function $p_v(v_k)$, and $\mathbf{f}(\cdot)$ and $\mathbf{h}(\cdot)$ are known functions which possible vary over time. Based upon the measurement equation, the measurement PDF can be computed from the state-space model measurement equation:

$$p(\mathbf{z}_k \mid \mathbf{x}_k^n) = p_v(\mathbf{z}_k - \mathbf{h}(\mathbf{x}_k)) \quad \text{(Equation 2)}$$

The predictive estimate of the state $\mathbf{x}_k$ at time k, computed using the state-space model and all measurements up to the time instant k -1, is described by a conditional PDF:

$$p(\mathbf{x}_k \mid \mathbf{z}^{k-1}) \quad \text{(Equation 3)}$$

where $\mathbf{z}^{k-1} = [\mathbf{z}_1,..., \mathbf{z}_{k-1}]$ represents all measurements up to the time instant k -1. The conditional PDF is provided by the estimator 104.

Based upon the measurement PDF and the predictive state estimate PDF, the predictive PDF for measurement data 115, i.e., the measurement predictive PDF, is computed using the Chapman-Kolmogorov equation:

$$p(\mathbf{z}_k \mid \mathbf{z}^{k-1}) = \int p(\mathbf{z}_k, \mathbf{x}_k \mid \mathbf{z}^{k-1}) d\mathbf{x}_k = \int p(\mathbf{z}_k \mid \mathbf{x}_k) p(\mathbf{x}_k \mid \mathbf{z}^{k-1}) d\mathbf{x}_k \quad \text{(Equation 4)}$$

where the at least one predictive measurement PDF $p(\mathbf{z}_k \mid \mathbf{x}_k)$ is derived from the measurement equation.

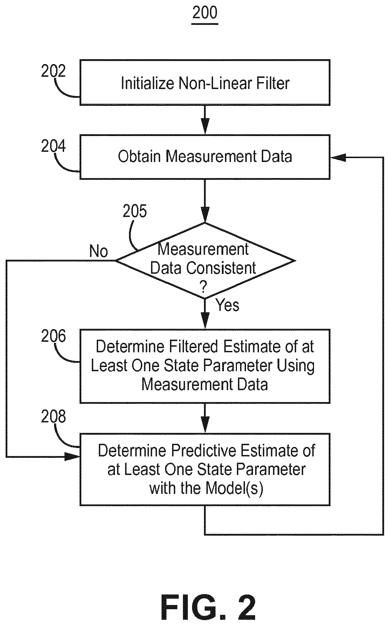

Figure 2 illustrates an exemplary method 200 of operation of at least one non-linear filter configured to provide at least one measurement predictive PDF 106. To the extent that the embodiment of method 200 shown in Figure 2 is described herein as being implemented in the system shown in Figure 1, it is to be understood that other embodiments can be implemented in other ways. The blocks of the flow diagrams have been arranged in a generally sequential manner for ease of explanation; however, it is to be understood that this arrangement is merely exemplary, and it should be recognized that the processing associated with the methods (and the blocks shown in the Figures) can occur in a different order (for example, where at least some of the processing associated with the blocks is performed in parallel and/or in an event-driven manner).

In block 202, initialize at least one non-linear filter by storing an a priori estimate of a state parameter. In one embodiment, initialization is performed by providing at least one PDF with an a priori estimate of the state.

Thus, at least one predictive PDF $p(\mathbf{x}_k \mid \mathbf{z}^{k-1})$ is determined, or computed. In one embodiment, the at least one non-linear estimator that provides at least one predictive PDF is at least one point mass filter (PMF). In this embodiment, the at least one predictive PDF is approximated by a point-mass density. The at least one predictive PDF can be determined, or computed, as follows:

$$p(\mathbf{x}_k \mid \mathbf{z}^{k-1}) \cong \sum_i P_{k|k-1}^{(i)}(\xi_k^{(i)}) S\{\mathbf{x}_k : \xi_k^{(i)}, \Delta_x\} \quad \text{(Equation 5)}$$

Where $\xi_k^{(i)} \in R^{n_x}$ is an i-th grid point, $i = 1, 2,..., N_x$, and $P_{k|k-1}^{(i)}(\xi_k^{(i)})$ is a respective value of the conditional PDF at the point, and $S\{\mathbf{x}_k^n : \xi_k^{(i)}, \delta_{LonLat}\}$ is a piece-wise constant (grid point selection) function of variable $\mathbf{x}_k^n$ at the point $\xi_k^{(i)}$ being one at a vicinity $\Delta_x$ of the point $\xi_k^{(i)}$ and zero otherwise. The vicinity $\Delta_x$ may or may not be the same for all grid points $\xi_k^{(i)}$.

In block 204, obtain (or load) measurement data 115. In block 205, determine if the measurement data 115 is consistent. Consistent measurement data is measurement data 115 that is in an expected range (or allowed area) of the at least one measurement predictive PDF as specified as follows. The at least one predictive measurement PDF is divided into two regions:

an allowed area where the measurement $\mathbf{z}_k$ is expected to be; and
a forbidden area where the measurement $\mathbf{z}_k$ is not expected to be.

The allowed and forbidden areas are defined by a probability of false alert, *e.g.* specified by a designer of the at least one non-linear filter configured to provide at least one measurement predictive PDF (NLF(s)) 106, and a shape of the at least one predictive measurement PDF. The specific methods for determining the allowed and forbidden areas are exemplified below with regards to a point mass filter (PMF), although other non-linear filters that provide the at least one predictive measurement PDF can be used; examples of other non-linear filters are provided above.

In one embodiment, if such measurement data 115 is not consistent, then proceed to block 208. If the measurement data 115 is consistent, then proceed to block 206. In block 206, determine, or compute, the filtered estimate of at least one state parameter with the non-linear filter using the measurement data 115.

In block 208, determine, or compute, the predictive estimate of at least one state parameter and at least one predictive measurement PDF with the non-linear filter using the models 116. The predictive measurement PDF is a new a priori estimate of the measurement data 115 to be subsequently measured. In one embodiment, at least one predictive PDF is determined, or computed, as described above with respect to Equation 5. In another embodiment, return to block 204 and continue the process.

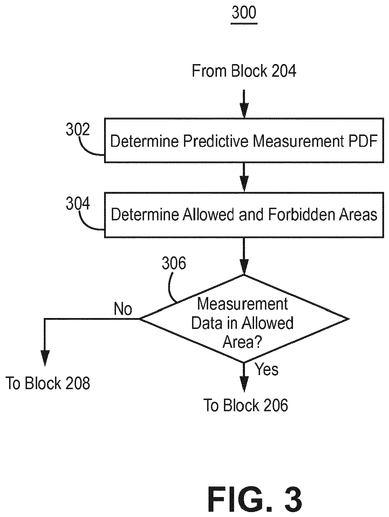

One embodiment of block 205 will now be described. Figure 3 illustrates one embodiment 300 of a method of determining if the measurement data 115 is consistent. To the extent that the embodiment of method 300 shown in Figure 3 is described here as being implemented in the system shown in Figure 1, it is to be understood that other embodiments can be implemented in other ways. The blocks of the flow diagrams have been arranged in a generally sequential manner for ease of explanation; however, it is to be understood that this arrangement is merely exemplary, and it should be recognized that the processing associated with the methods (and the blocks shown in the Figures) can occur in a different order (for example, where at least some of the processing associated with the blocks is performed in parallel and/or in an event-driven manner).

In block 302, determine, or compute the at least one predictive measurement PDF. In one embodiment, obtain from the block 202 or 208 (whichever last preceded block 302) the at least one predictive PDF, and then determine, or calculate, the at least one predictive measurement PDF.

In one embodiment, the at least one predictive measurement PDF is determined using the Chapman-Kolmogorov equation illustrated in Equation 4. When the non-linear filter is a point mass filter, the at least one predictive PDF is approximated, using a convolution, by the point-mass approximation:

$$p(\mathbf{z}_k \mid \mathbf{z}^{k-1}) \cong \sum_j P_{k|k-1}^{(j)}(\boldsymbol{\alpha}_k^{(j)}) S\{\mathbf{z}_k : \boldsymbol{\alpha}_k^{(j)}, \Delta_z\} \quad \text{(Equation 6)}$$

where the measurement grid is defined by the suitably selected equidistantly placed grid points spanning the expect range of the measurement:

$$\boldsymbol{\alpha}^{(j)} \in R^{n_z}, j = 1, 2, ..., N_z \quad \text{(Equation 7)}$$

and the probability of the *j*-th measurement grid point $\alpha^{(j)}$ is computed on the basis of the measurement PDF and the probability of the *i*-th state grid point $\xi_k^{(i)}$ by:

$$P_{k|k-1}^{(j)}(\boldsymbol{\alpha}_k^{(j)}) = \sum_{i=1}^{N_{LonLat}} p_v\left(\boldsymbol{\alpha}_k^{(j)} - \mathbf{h}(\xi_k^{(i)})\right) P_{k|k-1}^{(i)}(\xi_k^{(i)}), \forall j \quad \text{(Equation 8)}$$

The measurement data 115 should be within this region. The respective vicinity of the grid points is defined by $\Delta_z$. The vicinity $\Delta_z$ may or may not be the same for all grid points $\alpha^{(j)}$. The computation is performed in a manner analogous to computing the at least one predictive measurement PDF.

In block 304, determine the allowed and forbidden areas. The analysis for block 304 shall be exemplified for three embodiments.

For the first embodiment, the consistency test for the at least one measurement predictive PDF that is a unimodal PDF is described. For scalar unimodal PDFs, the consistency test is performed as follows. Based upon a probability of false alert $P_{FA}$, e.g. specified by the filter designer and a predictive measurement estimate PDF $p(\mathbf{z}_k \mid \mathbf{z}^{k-1})$ for a scalar measurement, the following quantiles are computed:

- quantile for $P_{FA,q1} = P_{FA} / 2$, denoted $\hat{z}_{q1,k|k-1}$, and
- quantile for

$$P_{FA,q2} = 1 - P_{FA} / 2, \text{ denoted } \hat{z}_{q2,k|k-1}. \quad \text{(Equation 9)}$$

Then, the allowed area is the range of possible measurement data between the quantiles:

$$\hat{z}_{q1,k|k-1} \leq z_k \leq \hat{z}_{q2,k|k-1} \quad \text{(Equation 10)}$$

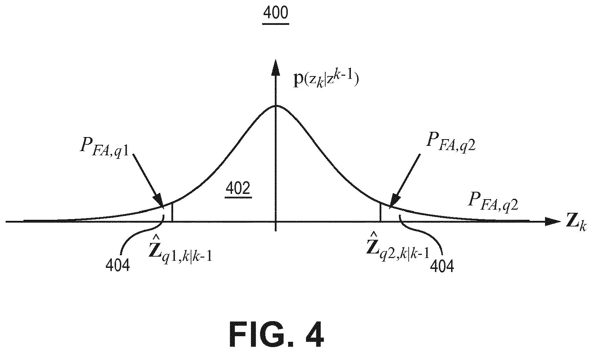

Measurement data 115 that falls within this range is deemed acceptable. If the measurement data 115 falls outside this range, i.e. in the forbidden area, the measurement data 115 is deemed faulty and is rejected. Figure 4 illustrates one embodiment of a scalar unimodal PDF 400 having an allowed area 402 and two forbidden areas 404.

Consistency testing may also be performed for multi-dimensional unimodal predictive measurement PDFs. In one embodiment, if measurement is considered to be a vector, the consistency of each measurement vector component may be evaluated as described above. However, this approach ignores the correlation between the measurement vector components. Alternatively, the consistency of the vector measurement considering the unimodal predictive measurement PDF can be determined using a hyper-ellipsoid. The hyper-ellipsoid E is computed to fulfill the following equation:

$$1 - P_{FA} = \int_E p(\mathbf{z}_k \mid \mathbf{z}^{k-1}) d\mathbf{z}_k \qquad \text{(Equation 11)}$$

The allowed region would be a part of a support, which is defined by the hyper-ellipsoid.

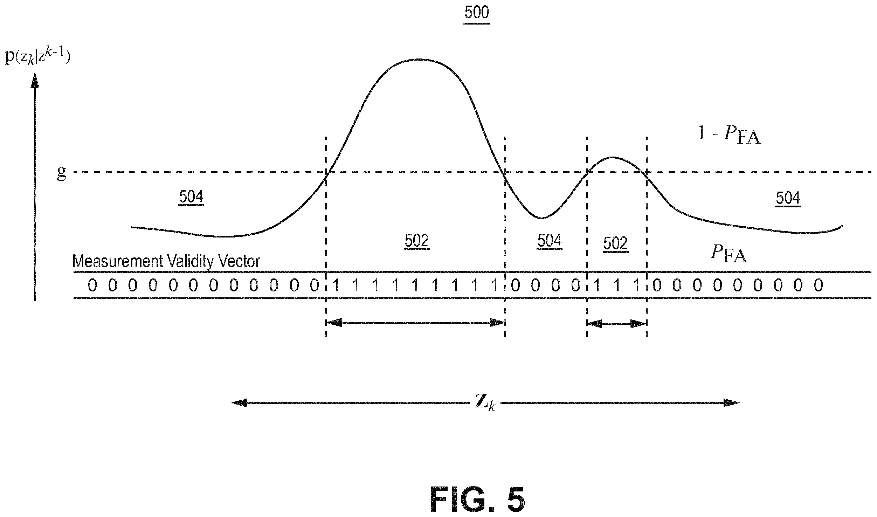

For the second embodiment, a consistency test for scalar multi-modal PDFs is described. Figure 5 illustrates one embodiment of a scalar multi-modal PDF 500 having two allowed areas 502 and three forbidden areas 504.

A conditional PDF of the measurement $\mathbf{z}_k$ at time $k$, equal to a probability value threshold g is determined, or calculated:

$$p(\mathbf{z}_k \mid \mathbf{z}^{k-1}) = g \qquad \text{(Equation 12)}$$

where volume of $p(\mathbf{z}_k \mid \mathbf{z}^{k-1})$ below the threshold g is equal to the probability of false alert $P_{FA}$, and volume of $p(\mathbf{z}_k \mid \mathbf{z}^{k-1})$ above the threshold g is equal to 1 - $P_{FA}$. In one embodiment, the probability of false alert is specified by a designer of the at least one non-linear filter.

Implemented with a PMF, the probability value threshold g is determined as follows:

• Probability Value Threshold g so that where:

$$\sum_{j=1}^{N_{z,g}} P_{k|k-1}^{(j)}(\alpha_k^{(j)})\Delta_z = 1 - P_{FA}$$

$$\text{(Equation 13)}$$

$N_{z,g}$ = indexes of points for which: $P_{k|k-1}^{(j)}(\alpha_k^{(j)})\Delta_z \geq g$

• Measurement Validity Vector $\upsilon_\alpha$

$$\upsilon_\alpha = \begin{cases} \upsilon_{\alpha(j)}=1 & \text{if } P_{k|k-1}^{(j)}(\alpha_k^{(j)})\Delta_z \geq g \\ \upsilon_{\alpha(j)}=0 & \text{if } P_{k|k-1}^{(j)}(\alpha_k^{(j)})\Delta_z < g \end{cases} \qquad \text{(Equation 14)}$$

The measurement validity vector $\upsilon_\alpha$ defines which areas determined by the expected measurement range $\alpha_k^{(j)}$ and the vicinity $\Delta_z$ are allowed areas 502 (where $\upsilon_{\alpha(j)}$=1), and thus likely to contain the measurement data 115 for the measurement $\mathbf{z}_k$; and are forbidden areas 504 (where $\upsilon_{\alpha(j)}$=0), and thus not likely to contain the measurement data 115 for the measurement $\mathbf{z}_k$. The regions where $P_{k|k-1}^{(j)}(\alpha_k^{(j)})\Delta_z \geq g$ are the allowed areas 502. The regions where $P_{k|k-1}^{(j)}(\alpha_k^{(j)})\Delta_z < g$ are the forbidden areas 504.

The measurement data 115 for measurement $\mathbf{z}_k$ is considered consistent with measurement prediction if the measurement data 115 falls within any of the allowed areas 502, and inconsistent if it falls within any of the forbidden areas 504. This means that distance between measurement $\mathbf{z}_k$ and the closest valid grid point is lower or equal to half of grid resolution: $\left| z_k - \alpha_k^{(N_{z,g})} \right| \leq \dfrac{\Delta_z}{2}$. Then, the measurement data 115 for the measurement $\mathbf{z}_k$ is used by the non-linear filter. Otherwise, the measurement data 115 for the measurement $\mathbf{z}_k$ is rejected and not further used by the non-linear filter to estimate state parameters.

In one embodiment, for multi-dimensional multi-modal predictive measurement PDFs, the predictive state estimate and the at least one predictive measurement PDF are determined as described above. In one embodiment, $n_z$,

marginal predictive measurement PDFs for each component of the measurement vector, are determined. Then, the consistency of each measurement vector component is evaluated as described above. Alternatively, the consistency of the multi-dimensional unimodal PDF can be determined using hyper-planes in $n_z$ dimensional space so that the allowed areas are above the hyper-plane. The hyper-plane with an orthogonal distance g from the support of the predictive measurement PDF is computed to fulfill the equality:

$$1 - P_{FA} = \int s(p(\mathbf{z}_k \mid \mathbf{z}^{k-1}), g) p(\mathbf{z}_k \mid \mathbf{z}^{k-1}) d\mathbf{z}_k \quad \text{(Equation 15)}$$

where $s(p(\mathbf{z}_k \mid \mathbf{z}^{k-1}), g)$ is a selection function being 1 if $p(\mathbf{z}_k \mid \mathbf{z}^{k-1}) > g$ and 0 otherwise.

For the third embodiment, a consistency test can be performed on unimodal or multi-modal scalar or multi-dimensional at least one predictive measurement PDF using approximation. The mean and covariance matrix of the at least one predictive measurement PDF $p(\mathbf{z}_k \mid \mathbf{z}^{k-1})$ are determined. Assuming a Gaussian distribution of the at least one predictive measurement PDF with the mean and covariance matrix, the quantiles of the approximate Gaussian at least one predictive measurement estimate PDF for the probability of false alert $P_{FA}$ are straightforwardly determined, and, *e.g.* stored or defined in at least one look up table, *e.g.* specifying a range of $\mathbf{z}_k$ that defines allowable area(s) for a given $P_{FA}$. In one embodiment, the at least one look up table is part of the consistency test 114. Consistency can be determined if the measurement data 115 falls within the allowable area(s) that are between $\hat{z}_{q1,k|k-1} \le z_x \le \hat{z}_{q2,k|k-1}$, where $\hat{z}_{q1,k|k-1}$ is a Gaussian PDF quantile with $P_{FA} / 2$ and $\hat{z}_{q2,k|k-1}$ is a Gaussian PDF quantile with 1 - $P_{FA} / 2$.

When utilizing a point mass filter, the mean and covariance matrices of the at least one predictive measurement PDF are respectively determined as follows:

Mean Matrix:

$$\hat{\mathbf{z}}_{k|k-1} = \sum_j \boldsymbol{\alpha}_k^{(j)} P_{k|k-1}^{(j)} (\boldsymbol{\alpha}_k^{(j)}) \Delta_z \quad \text{(Equation 15)}$$

Covariance Matrix:

$$\mathbf{P}_{z,k|k-1} = \sum_j P_{k|k-1}^{(j)} (\boldsymbol{\alpha}_k^{(j)}) \Delta_z \left( \boldsymbol{\alpha}_k^{(j)} - \hat{\mathbf{z}}_{k|k-1} \right) \left( \boldsymbol{\alpha}_k^{(j)} - \hat{\mathbf{z}}_{k|k-1} \right)^T \quad \text{(Equation 16)}$$

A Gaussian distribution of the PDF $p(\mathbf{z}_k \mid \mathbf{z}^{k-1})$ is assumed. As a result, the above described look up table(s) can be created based upon these two moments. Consistency can be determined if the measurement falls within the allowable area(s). Determining whether the at least one predictive measurement PDF is close to a Gaussian PDF (i.e., the assumption used in the third embodiment holds) can be performed by evaluating the moments of the PDF, like those described in Equation 16.

Returning to Figure 3, in block 306, determine if the measurement data 115 is in an allowed area. In one embodiment, if the measurement data 115 for measurement $\mathbf{z}_k$ is in an allowed area, then proceed to block 206. The measurement data 115 for measurement $\mathbf{z}_k$ is deemed consistent with the at least one predictive measurement PDF, and is used by the at least one non-linear filter 106 to determine, or compute, a filtered estimate of at least one state parameter. In another embodiment, if the measurement data 115 for measurement $\mathbf{z}_k$ is in the forbidden area, then proceed to block 208. The measurement data 115 for measurement $\mathbf{z}_k$ is deemed inconsistent, *e.g.* rejected, and the computation of the filtered estimate of the at least one state parameter is skipped and a predictive state estimate is computed.

**Claims**

1. A system (102), comprising:

   at least one sensor (105);
   a processing system (109) comprising a memory (110) coupled to a processor (112);
   wherein the processing system (109) is configured to be coupled to the at least one sensor;
   wherein the memory (110) comprises a consistency test (114), at least one model (116), measurement data (115), and an estimator (104), wherein the at least one model (116) comprises a state space model for at least one of a direct estimation of a state parameter and an indirect estimation of the state parameter;
wherein the measurement data (115) comprises data measured by the at least one sensor (105);
wherein the estimator (104) comprises at least one non-linear filter (106) which is configured to provide at least one predictive measurement estimate probability density function (PDF);
wherein the estimator (104) is configured to generate the at least one predictive measurement estimate PDF using the at least one model, and the consistency test (114) is configured to determine if the measurement data (115) is within at least one allowable area of the at least one predictive measurement estimate PDF;
wherein the at least one allowable area is a region where the measurement data is expected to be; and
wherein if the measurement data (115) is determined to be within at least one allowable area, then the estimator (104) estimates at least one state parameter using the measurement data (115).

2. The system (102) of claim 1, wherein the at least one non-linear filter (106) comprises at least one of a point mass filter, a particle filter, and a Gaussian sum filter.

3. The system (102) of claim 1, wherein the at least one allowable area (402) comprises:

$$\hat{z}_{q1,k|k-1} \leq z_k \leq \hat{z}_{q2,k|k-1};$$

where $z_k$ is a measurement;

where $\hat{z}_{q1,k|k-1}$ is a quantile, of the at least one predictive measurement estimate PDF, for $P_{FA} / 2$;
$\hat{z}_{q2,k-1}$ is a quantile, of the at least one predictive measurement estimate PDF, for $1-P_{FA}/2$; and
$P_{FA}$ is a probability of a false alert.

4. The system (102) of claim 1, wherein the at least one non-linear filter (106) comprises at least one point mass filter;
wherein the at least one allowable area (502) comprises at least one volume of

$$p(\mathbf{z}_k \mid \mathbf{z}^{k-1}) \text{ above } p(\mathbf{z}_k \mid \mathbf{z}^{k-1}) = g \text{ equals } 1 - P_{FA};$$

wherein $\mathbf{z}_k$ is a measurement;
wherein $P_{FA}$ is a probability of a false alert;
wherein the at least one allowable area comprises $P_{k|k-1}^{(j)}(\alpha_k^{(j)})\Delta_z \geq g;$
wherein $g = p(\mathbf{z}_k \mid \mathbf{z}^{k-1});$
wherein a region of $p(\mathbf{z}_k \mid \mathbf{z}^{k-1})$ below the threshold g is equal to the probability of false alert $P_{FA}$, and a region of $p(\mathbf{z}_k \mid \mathbf{z}^{k-1})$ above the threshold g is equal to $1 - P_{FA}$; and
wherein $\alpha_k^{(j)}$ is an expected measurement range and $\Delta_z$ is its vicinity.

5. The system (102) of claim 1, where the at least one allowable area is defined in a lookup table.

6. A method, comprising:

initializing at least one non-linear filter (106) configured to provide at least one predictive measurement estimate probability density function (PDF);
obtaining measurement data (115) from at least one sensor;
determining if the measurement data (115) is consistent with a consistency test (114);
wherein consistent measurement data is measurement data in an expected range;
if the measurement data (115) is consistent, then determining a filtered estimate of at least one state parameter with the at least one non-linear filter (106) using the measurement data (115); and
determining a predictive estimate, with the at least one non-linear filter (106) and at least one model (116), of at least one state parameter using the measurement data (115);
wherein the at least one model (116) comprises a state space model for at least one of a direct estimation of a state parameter and an indirect estimation of the state parameter; and
wherein determining if the measurement data (115) is consistent comprises:

determining the at least one predictive measurement estimate PDF;

determining at least one allowed area and at least one forbidden area in the at least one predictive measurement estimate PDF; and

determining if the measurement data is within the at least one allowed area of the at least one predictive measurement estimate PDF.

7. The method of claim 8, wherein determining the at least one predictive measurement estimate PDF comprises determining

$$p(\mathbf{z}_k \mid \mathbf{z}^{k-1}) = \int p(\mathbf{z}_k, \mathbf{x}_k \mid \mathbf{z}^{k-1}) d\mathbf{x}_k = \int p(\mathbf{z}_k \mid \mathbf{x}_k) p(\mathbf{x}_k \mid \mathbf{z}^{k-1}) d\mathbf{x}_k \, ;$$

and wherein the at least one predictive measurement estimate PDF $p(\mathbf{z}_k \mid \mathbf{x}_k)$ is derived from a measurement equation;

wherein $\mathbf{x}_k$ is an unknown state at time k; and

wherein $\mathbf{z}_k$ is a measurement.

8. The method of claim 8, wherein determining if the measurement data (115) is within the at least one allowable area of the at least one predictive measurement estimate PDF comprises determining if the measurement data is within one allowable area (402) of the at least one predictive measurement estimate PDF specified by:

$$\hat{z}_{q1,k|k-1} \leq z_k \leq \hat{z}_{q2,k|k-1} \, ;$$

where $z_k$ is a measurement;

where $\hat{z}_{q1,k|k-1}$ is a quantile, of the predictive measurement estimate PDF, for is $P_{FA} / 2$;

$\hat{z}_{q2,k|k-1}$ is a quantile, of the predictive measurement estimate PDF, for is $1-P_{FA}/2$; and

$P_{FA}$ is a probability of a false alert.

**Patentansprüche**

1. System (102), umfassend:

mindestens einen Sensor (105);

ein Verarbeitungssystem (109), das einen Speicher (110), der mit einem Prozessor (112) gekoppelt ist, umfasst;

wobei das Verarbeitungssystem (109) dazu konfiguriert ist, mit dem mindestens einem Sensor gekoppelt zu werden;

wobei der Speicher (110) einen Konsistenztest (114), mindestens ein Modell (116), Messdaten (115) und einen Schätzer (104) umfasst, wobei das mindestens eine Modell (116) ein Zustandsraummodell für mindestens eine von einer direkten Schätzung eines Zustandsparameters und einer indirekten Schätzung des Zustandsparameters umfasst;

wobei die Messdaten (115) Daten umfassen, die durch den mindestens einen Sensor (105) gemessen werden;

wobei der Schätzer (104) mindestens einen nichtlinearen Filter (106) umfasst, der dazu konfiguriert ist, mindestens eine prognostische Messschätzungswahrscheinlichkeitsdichtefunktion (PDF, probability density function) bereitzustellen;

wobei der Schätzer (104) dazu konfiguriert ist, die mindestens eine prognostische Messschätzungs-PDF unter Verwendung des mindestens einen Modells zu erzeugen, und der Konsistenztest (114) dazu konfiguriert ist, zu bestimmen, ob die Messdaten (115) innerhalb mindestens eines zulässigen Gebiets der mindestens einen prognostischen Messschätzungs-PDF liegen;

wobei das mindestens eine zulässige Gebiet eine Region ist, in der die Messdaten erwartet werden; und

wobei dann, wenn bestimmt wird, dass die Messdaten (115) innerhalb mindestens eines zulässigen Gebiets liegen, der Schätzer (104) mindestens einen Zustandsparameter unter Verwendung der Messdaten (115) schätzt.

2. System (102) nach Anspruch 1, wobei der mindestens eine nichtlineare Filter (106) mindestens einen von einem Punktmassenfilter, einem Partikelfilter und einem Gaußschen Summenfilter umfasst.

3. System (102) nach Anspruch 1, wobei das mindestens eine zulässige Gebiet (402) umfasst:

$$\hat{Z}_{q1,k|k-1} \le Z_k \le \hat{Z}_{q2,k|k-1};$$

wobei $z_k$-eine Messung ist;
wobei $\hat{Z}_{q1,k|k-1}$ ein Quantil der mindestens einen prognostischen Messschätzungs-PDF für $P_{FA}/2$ ist;
$\hat{Z}_{q2,k|k-1}$ ein Quantil der mindestens einen prognostischen Messschätzungs-PDF für $1-P_{FA}/2$ ist; und
$P_{FA}$ eine Wahrscheinlichkeit eines Fehlalarms ist.

4. System (102) nach Anspruch 1, wobei der mindestens eine nichtlineare Filter (106) mindestens einen Punktmassenfilter umfasst;
wobei das mindestens eine zulässige Gebiet (502) mindestens ein Volumen von $p(z_k|z^{k-1})$ über $p(z_k|z^{k-1})$ = g gleich
1 - $P_{FA}$ umfasst;
wobei $z_k$ eine Messung ist;
wobei $P_{FA}$ eine Wahrscheinlichkeit eines Fehlalarms ist;

$$P_{k|k-1}^{(j)}\left(\alpha_k^{(j)}\right)\Delta_z \ge g;$$

wobei das mindestens eine zulässige Gebiet umfasst:

wobei g = $p(z_k|z^{k-1})$ ist;
wobei eine Region von $p(z_k|z^{k-1})$ unterhalb der Schwelle g gleich der Wahrscheinlichkeit eines Fehlalarms $P_{FA}$
ist und eine Region von $p(z_k|z^{k-1})$ oberhalb der Schwelle g gleich 1 - $P_{FA}$ ist; und
wobei $\alpha_k^{(j)}$ ein erwarteter Messbereich ist und $\Delta_z$ dessen nahe Umgebung ist.

5. System (102) nach Anspruch 1, wobei das mindestens eine zulässige Gebiet in einer Nachschlagetabelle definiert ist.

6. Verfahren, umfassend:

Initialisieren mindestens eines nichtlinearen Filters (106), der dazu konfiguriert ist, mindestens eine prognostische Messschätzungswahrscheinlichkeitsdichtefunktion (PDF) bereitzustellen;
Erhalten von Messdaten (115) von mindestens einem Sensor;
Bestimmen, ob die Messdaten (115) konsistent sind, mit einem Konsistenztest (114);
wobei konsistente Messdaten Messdaten in einem erwarteten Bereich sind;
wenn die Messdaten (115) konsistent sind, dann Bestimmen einer gefilterten Schätzung von mindestens einem Zustandsparameter mit dem mindestens einen nichtlinearen Filter (106) unter Verwendung der Messdaten (115); und
Bestimmen einer prognostischen Schätzung mindestens eines Zustandsparameters mit dem mindestens einen nichtlinearen Filter (106) und mindestens einem Modell (116) unter Verwendung der Messdaten (115);
wobei das mindestens eine Modell (116) ein Zustandsraummodell für mindestens eine von einer direkten Schätzung eines Zustandsparameters und einer indirekten Schätzung des Zustandsparameters umfasst; und
wobei das Bestimmen, ob die Messdaten (115) konsistent sind, umfasst:

Bestimmen der mindestens einen prognostischen Messschätzungs-PDF;
Bestimmen mindestens eines zulässigen Gebiets und mindestens eines verbotenen Gebiets in der mindestens einen prognostischen Messschätzungs-PDF; und
Bestimmen, ob die Messdaten innerhalb des mindestens einen zulässigen Gebiets der mindestens einen prognostischen Messschätzungs-PDF liegen.

7. Verfahren nach Anspruch 8, wobei das Bestimmen der mindestens einen prognostischen Messschätzungs-PDF umfasst: Bestimmen von

$$p(z_k|z^{k-1}) = \int p(z_k, x_k|z^{k-1})dx_k = \int p(z_k|x_k)p(x_k|z^{k-1})dx_k;$$

und wobei die mindestens eine prognostische Messschätzungs-PDF $p(z_k|x_k)$ aus einer Messgleichung abgeleitet

wird;

wobei $x_k$ ein unbekannter Zustand zum Zeitpunkt k ist und
wobei $z_k$ eine Messung ist.

**8.** Verfahren nach Anspruch 8, wobei das Bestimmen, ob die Messdaten (115) innerhalb des mindestens einen zulässigen Gebiets der mindestens einen prognostischen Messschätzungs-PDF liegen, das Bestimmen umfasst, ob die Messdaten innerhalb eines wie folgt festgelegten zulässigen Gebiets (402) der mindestens einen prognostischen Messschätzungs-PDF liegen:

$$\hat{Z}_{q1,k|k-1} \leq Z_k \leq \hat{Z}_{q2,k|k-1};$$

wobei $z_k$ eine Messung ist;
wobei $\hat{Z}_{q1,k|k-1}$ ein Quantil der prognostischen Messschätzungs-PDF ist, für $P_{FA}/2$ ist; $\hat{Z}_{q2,k|k-1}$ ein Quantil der prognostischen Messschätzungs-PDF ist, für $1\text{-}P_{FA}/2$ ist; und $P_{FA}$ eine Wahrscheinlichkeit eines Fehlalarms ist.

## Revendications

**1.** Système (102) comprenant :

au moins un capteur (105) ;
un système de traitement (109) comprenant une mémoire (110) couplée à un processeur (112) ;
dans lequel le système de traitement (109) est configuré pour être couplé à le au moins un capteur ;
dans lequel la mémoire (110) comprend un test de cohérence (114), au moins un modèle (116), des données de mesure (115) et un estimateur (104), dans lequel le au moins un modèle (116) comprend un modèle d'espace d'états pour au moins un élément parmi une estimation directe d'un paramètre d'état et une estimation indirecte du paramètre d'état ;
dans lequel les données de mesure (115) comprennent des données mesurées par le au moins un capteur (105) ;
dans lequel l'estimateur (104) comprend au moins un filtre non linéaire (106) configuré pour fournir au moins une fonction de densité de probabilité (PDF, probability density function) d'estimation de mesure prédictive ;
dans lequel l'estimateur (104) est configuré pour générer la au moins une PDF d'estimation de mesure prédictive en utilisant le au moins un modèle et le test de cohérence (114) est configuré pour déterminer si les données de mesure (115) se trouvent au sein d'au moins une zone autorisée de la au moins une PDF d'estimation de mesure prédictive ;
dans lequel la au moins une zone autorisée est une région dans laquelle les données de mesure sont censées se trouver ; et
dans lequel, si les données de mesure (115) sont déterminées comme se trouvant au sein d'au moins une zone autorisée, alors l'estimateur (104) estime au moins un paramètre d'état en utilisant les données de mesure (115).

**2.** Système (102) selon la revendication 1, dans lequel le au moins un filtre non linéaire (106) comprend au moins un élément parmi un filtre de masse ponctuelle, un filtre à particules et un filtre à somme gaussienne.

**3.** Système (102) selon la revendication 1, dans lequel la au moins une zone autorisée (402) comprend :

$$\hat{Z}_{q1,k|k-1} \leq Z_k \leq \hat{Z}_{q2,k|k-1};$$

où $z_k$- représente une mesure ;
où $\hat{Z}_{q1,k|k-1}$ représente un quantile de la au moins une PDF d'estimation de mesure prédictive, pour $P_{FA}/2$;
$\hat{Z}_{q2,k|k-1}$ représente un quantile de la au moins une PDF d'estimation de mesure prédictive, pour $1\text{-}P_{FA}/2$ ; et
$P_{FA}$ représente une probabilité de fausse alerte.

**4.** Système (102) selon la revendication 1, dans lequel le au moins un filtre non linéaire (106) comprend au moins un filtre de masse ponctuelle ;
dans lequel la au moins une zone autorisée (502) comprend au moins un volume de $p(z_k \mid z^{k-1})$ au-dessus de $p(z_k$

| $z^{k-1}$) = g égal à 1 - $P_{FA}$;

dans lequel $z_k$ représente une mesure ;

dans lequel $P_{FA}$ représente une probabilité de fausse alerte ;

dans lequel la au moins une zone autorisée comprend

$$P_{k|k-1}^{(j)}\left(\alpha_k^{(j)}\right)\Delta_z \geq g \ ;$$

dans lequel $g = p(z_k \mid z^{k-1})$;

dans lequel une région de $p(z_k \mid z^{k-1})$ au-dessous du seuil g est égale à la probabilité de fausse alerte $P_{FA}$ et une région de $p(z_k \mid z^{k-1})$ au-dessus du seuil g est égale à 1 - $P_{FA}$; et

dans lequel $\alpha_k^{(j)}$ représente une plage de mesure attendue et $\Delta_z$ représente son voisinage.

5. Système (102) selon la revendication 1, la au moins une zone autorisée étant définie dans une table de consultation.

6. Procédé comprenant :

l'initialisation d'au moins un filtre non linéaire (106), configuré pour fournir au moins une fonction de densité de probabilité (PDF) d'estimation de mesure prédictive ;

l'obtention de données de mesure (115) à partir d'au moins un capteur ;

la détermination pour savoir si les données de mesure (115) sont cohérentes selon un test de cohérence (114) ;

dans lequel des données de mesure cohérentes sont des données de mesure dans une plage attendue ;

si les données de mesure (115) sont cohérentes, alors la détermination d'une estimation filtrée d'au moins un paramètre d'état à l'aide du au moins un filtre non linéaire (106) selon les données de mesure (115) ; et

la détermination d'une estimation prédictive, à l'aide du au moins un filtre non linéaire (106) et d'au moins un modèle (116), d'au moins un paramètre d'état selon les données de mesure (115) ;

dans lequel le au moins un modèle (116) comprend un modèle d'espace d'états pour au moins une estimation parmi une estimation directe d'un paramètre d'état et une estimation indirecte du paramètre d'état ; et

dans lequel la détermination pour savoir si les données de mesure (115) sont cohérentes comprend :

la détermination de la au moins une PDF d'estimation de mesure prédictive ;

la détermination d'au moins une zone autorisée et d'au moins une zone interdite dans la au moins une PDF d'estimation de mesure prédictive ; et

la détermination pour savoir si les données de mesure se trouvent au sein d'au moins une zone autorisée de la au moins une PDF d'estimation de mesure prédictive.

7. Procédé selon la revendication 8, dans lequel la détermination de la au moins une PDF d'estimation de mesure prédictive comprend la détermination de

$$p\left(z_k \middle| z^{k-1}\right) = \int p\left(z_k, x_k \middle| z^{k-1}\right) dx_k = \int p\left(z_k \middle| x_k\right) p(x_k \middle| z^{k-1}) dx_k \ ;$$

et dans lequel la au moins une PDF d'estimation de mesure prédictive $p(z_k \mid x_k)$ est dérivée d'une équation de mesure ;

dans lequel $x_k$ représente un état inconnu au temps *k* et

dans lequel $z_k$ représente une mesure.

8. Procédé selon la revendication 8, dans lequel la détermination pour savoir si les données de mesure (115) se trouvent au sein de la au moins une zone autorisée de la au moins une PDF d'estimation de mesure prédictive comprend la détermination pour savoir si les données de mesure se trouvent au sein d'une zone autorisée (402) de la au moins une PDF d'estimation de mesure prédictive spécifiée par :

$$\hat{Z}_{q1,k|k-1} \leq Z_k \leq \hat{Z}_{q2,k|k-1};$$

où $z_k$ représente une mesure ;

où $\hat{Z}_{q1,k|k-1}$ représente un quantile de la PDF d'estimation de mesure prédictive, pour $P_{FA}$ / 2;

$\hat{Z}_{q2,k|k-1}$ représente un quantile de la PDF d'estimation de mesure prédictive pour $1-P_{FA}/2$ ; et $P_{FA}$ représente une probabilité de fausse alerte.

**FIG. 1**

200

202 — Initialize Non-Linear Filter

204 — Obtain Measurement Data

205 — Measurement Data Consistent ?

No

Yes

206 — Determine Filtered Estimate of at Least One State Parameter Using Measurement Data

208 — Determine Predictive Estimate of at Least One State Parameter with the Model(s)

# FIG. 2

<u>300</u>

From Block 204

302 Determine Predictive Measurement PDF

304 Determine Allowed and Forbidden Areas

306

No ◁ Measurement Data in Allowed Area? ▷ Yes

To Block 208

To Block 206

# FIG. 3

FIG. 4

**FIG. 5**